# EUROPEAN PATENT SPECIFICATION

(11) **EP 0 410 421 B1**
(45) Date of publication and mention of the grant of the patent: **09.12.1998**
(21) Application number: 90114267.9
(22) Date of filing: 25.07.1990
(51) Int. Cl.: H01L 21/00

(54) **Use of a semiconductor device support carrier**
Verwendung eines Trägers für Halbleiteranordnung
L'utilisation d'un support pour dispositif semi-conducteur

(30) Priority: 25.07.1989 JP 192272/89
(43) Date of publication of application: 30.01.1991
(73) Proprietor: KABUSHIKI KAISHA TOSHIBA, Kawasaki-shi, Kanagawa-ken 210 (JP)
(72) Inventor: Kodera, Masako, Matsodu-Shi, Chiba-Ken (JP); Watanabe, Tohru, Yokohama-Shi, Kanagawa-Ken (JP); Okumura, Katsuya, Midori-Ku, Yokohama-Shi, Kanagawa-Ken (JP)
(74) Representative: Lehn, Werner, Dipl.-Ing.

(56) References cited:
- DE-A- 2 459 892
- US-A- 4 696 395
- IBM TECHNICAL DISCLOSURE BULLETIN. vol. 14, no. 8, January 1972, NEW YORK US page 2317 H.H. HUSTIS ET AL.: "Mask transportation and storage container"
- PATENT ABSTRACTS OF JAPAN vol. 12, no. 187 (E-615)(3034) 31 May 1988, & JP-A-62 291044 (NEC) 17 December 1987,

## Description

### BACKGROUND OF THE INVENTION

The present invention relates to the use of a semiconductor wafer support carrier in a liquid phase process of semiconductor wafers, and more particularly to the use of a semiconductor wafer support carrier which prevents dust from adhering to the surfaces of semiconductor wafers.

In semiconductor wafer manufacturing processes, the wafers undergo a variety of liquid phase processes. For example, semiconductor wafers undergo a washing process which removes impurities from the surfaces of the semiconductor wafers, and they undergo an LPD process which forms an SiO₂ film on the surfaces of the semiconductor wafers by a precipitation reaction in a supersaturated solution.

In these liquid phase processes, the semiconductor wafers are supported by the semiconductor wafer support carrier, and the semiconductor wafer support carrier supporting the semiconductor wafers is put into and taken out of a process liquid.

However, when the semiconductor wafer support carrier is drawn up from the process liquid, it often happens that the dust and the like of the process liquid adheres to the surfaces of the semiconductor wafers. In this case, minute pattern forming processes and the like thereafter are affected by this adhering dust.

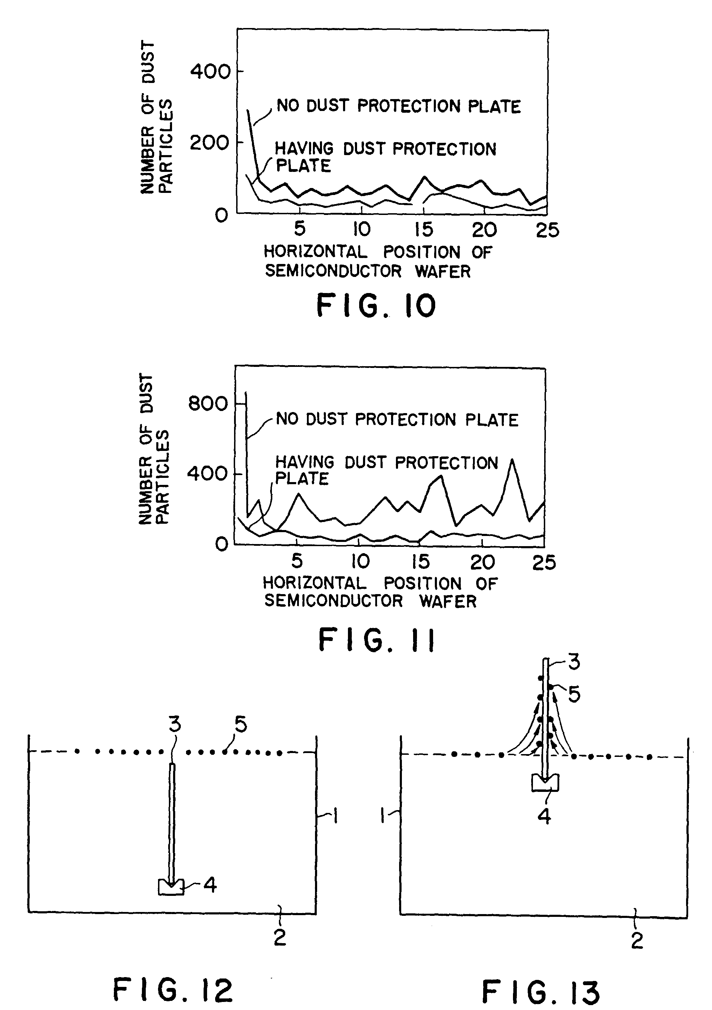

Fig. 12 shows a conventional semiconductor wafer support carrier.

In Fig. 12, a liquid phase process apparatus 1 contains process liquid 2. A conventional semiconductor wafer support carrier 4 supports semiconductor wafers 3. The semiconductor wafers 3 are dipped within the process liquid 2, and much dust 5 floats on the surface of the process liquid 2.

When the semiconductor wafers 3 are drawn up from the process liquid 2 by the semiconductor wafer support carrier 4 after the liquid phase process, tne dust 5 on the surface of the process liquid 2 adheres to the surface of the semiconductor wafers 3.

In the semiconductor wafer washing process in which it is easy to secure the cleanliness of the process liquid 2, the amount of dust adhering to the surfaces of the semiconductor wafer and having diameters of over 0.3 µm, is in the order of several tens to several hundreds per semiconductor wafer having a diameter of 5 inches (1 inch= 2.54 cm).

On the other hand, in a resist exfoliation process or LPD process in which it is easy for dust to form, the amount of dust per semiconductor wafer is about 100 ∼ about 1000 particles.

The dust adhering to the surfaces of the semiconductor wafer 3 causes much trouble in the minute pattern forming process of the semiconductor wafers thereafter.

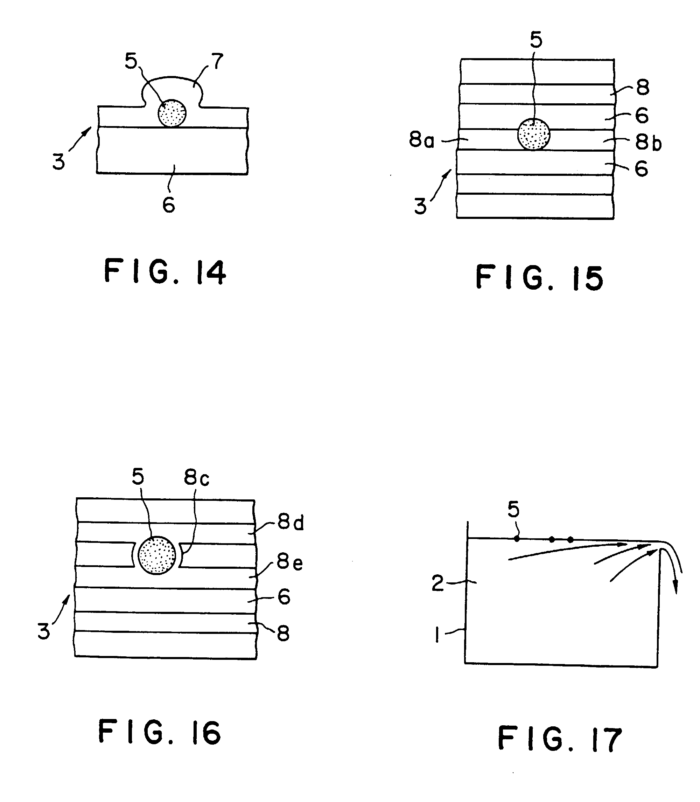

These phenomena are shown in Figs. 14∼16.

Fig. 14 shows the sectional side view of the semiconductor wafer. In Fig. 14, a numeral reference 6 is a substrate of the semiconductor wafer. A dust particle 5 adheres to the surface of the substrate 6 during the liquid phase process of the semiconductor wafer. After that, a wiring material 7 is formed on the surface of the substrate 6.

Next, wiring portions 8 are formed by etching the wiring material 7 of Fig. 14 (see Figs. 15 and 16). Figs. 15 and 16 show the top views of the semiconductor wafer.

However, it happens that the wiring portions 8 are separated by the dust 5 as shown in Fig. 15, when the wiring material 7 of Fig. 14 is etched. In this case, the wiring portions 8a and 8b which should be properly connected, are separated by the dust 5, so that the wiring formation of the semiconductor wafer becomes worse.

It also happens that the etching rest portion 8c remains as shown in Fig. 16, when the wiring material 7 of Fig. 14 is etched. In this case, the wiring portions 8d and 8e which should not normally be connected, are connected to each other through the etching rest portion 8c, so that the wiring formation of the semiconductor wafer deteriorates further.

The method where the dusts are discharged with the process liquid overflowing has been employed in order to prevent the dust from adhering. The amount of dust of the process liquid is decreased to some degree by the method as mentioned above, but the result of the method is not so apparent. This is because the dust 5 around the bottom of the process liquid is discharged but almost all the dust around the surface of the process liquid remains as shown in Fig. 17.

Thus, in the conventional liquid process, when the semiconductor wafer support carrier is drawn up from the process liquid, the dust 5 of the process liquid 2 adheres to the surfaces of the semiconductor wafers 3 so that the minute pattern forming process thereafter is affected by the dust which has adhered.

JP-A-62-291044 describes a semiconductor wafer carrier for use during centrifugal drying in which a cover is provided on top of the wafer carrier. This cover is removed during operations such as cleansing, etching or washing.

### SUMMARY OF THE INVENTION

It is an object of the present invention to provide a semiconductor wafer support carrier which prevents dust from adhering to the surfaces of semiconductor wafers when the semiconductor wafers are drawn up from process liquid.

The foregoing object is accomplished, according to one aspect of the invention, by the use of a semiconductor wafer support carrier in the processing, in a liquid, of a semiconductor wafer, for preventing dust from adhering to the surfaces of said wafer supported in said carrier when the carrier and wafer are drawn up from the process liquid, the support carrier comprising: a support frame supporting the semiconductor wafer, and a dust protection plate mounted on the support frame and positioned above the semiconductor wafer so as to cover the same, wherein the semiconductor wafer support carrier is drawn up from the process liquid during said processing and dust in the process liquid is pushed away from the wafer by said dust protection plate.

According to another aspect of the invention, there is provided the use of a semiconductor wafer support carrier in the processing, in a liquid, of a semiconductor wafer, for preventing dust from adhering to the surfaces of said wafer supported in said carrier when the carrier and wafer are drawn up from the process liquid, the support carrier comprising: a support frame supporting the semiconductor wafer, and two vertical dust protection plates mounted on the support frame with the wafer positioned vertically between them, wherein the upper end of each of said dust protection plates is bent inwardly, the upper edge of the wafer being situated below said inwardly bent portions so that as the semiconductor wafer support carrier is drawn up from the process liquid during said processing, dust in the process liquid is pushed away from the wafer by the inwardly bent ends of the dust protection plates.

In this invention, dust in the process liquid is pushed aside out of the semiconductor wafer by the dust protection when the semiconductor wafer support carrier is drawn up from the process liquid.

The present invention will be better understood from the following detailed description, given by way of example and referring to the accompanying drawings.

### BRIEF DESCRIPTION OF THE DRAWINGS

Fig. 1 is a side view showing a first example of a semiconductor wafer support carrier which can be used in accordance with the present invention.
Fig. 2 is a front view of the wafer support carrier;
Figs. 3 and 4 are front views showing a second semiconductor wafer support carrier which can be used in accordance with the present invention;
Fig. 5 is a front view showing a third semiconductor wafer support carrier which can be used in accordance with the present invention;
Fig. 6 is a side view showing a fourth semiconductor wafer support carrier which can be used in accordance with the present invention;
Fig. 7 is a side view showing a fifth semiconductor wafer support carrier which can be used in accordance with the present invention;
Fig. 8 is a side view showing a sixth semiconductor wafer support carrier which can be used in accordance with the present invention;
Fig. 9 is a side view showing a seventh semiconductor wafer support carrier which can be used in accordance with the present invention;
Figs. 10 and 11 are graphs showing the results of particular ways of performing the present invention.
Figs. 12 and 13 are side views showing a conventional semiconductor wafer support carrier;
Fig. 14 is a sectional side view showing a semiconductor wafer which has dust inside a wiring material;
Figs. 15 and 16 are plan views showing a semiconductor wafer which has dust inside a wiring portion;
Fig. 17 is a side view showing the flbw of the dust in the process liquid.

### DETAILED DESCRIPTION OF PREFERRED WAYS OF PERFORMING THE INVENTION

The way of using a semiconductor wafer support carrier in accordance with the present invention will become understood from the following detailed description.

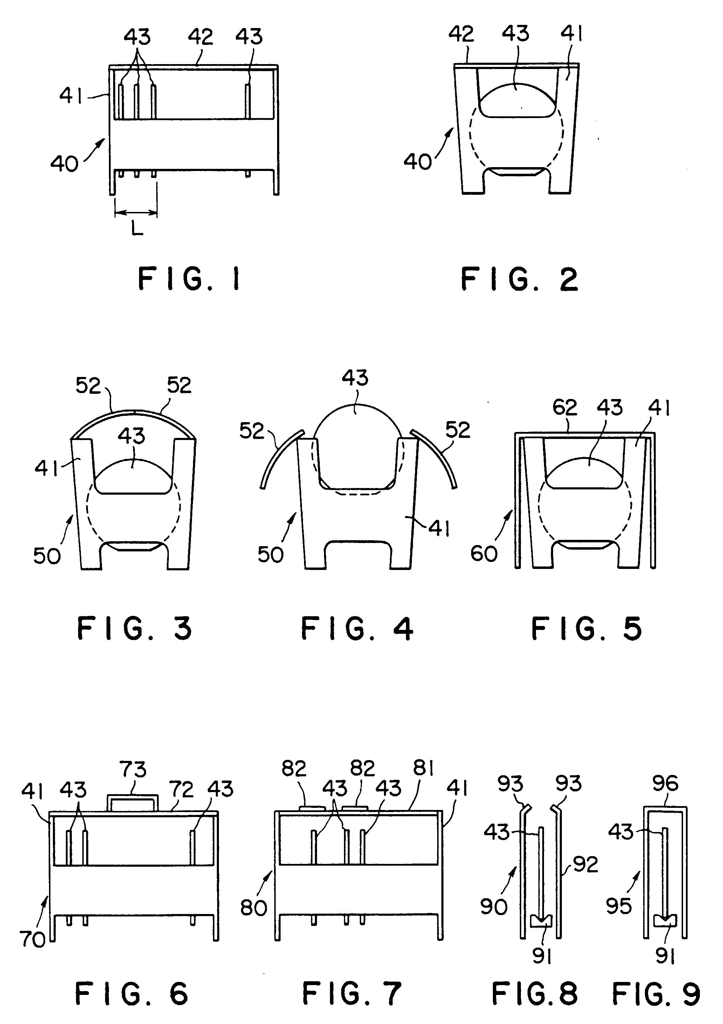

As shown in Figs. 1 and 2, the semiconductor wafer support carrier 40 is provided with a support frame 41 which contains a plurality of semiconductor wafers 43. The support frame 41 surrounds the semiconductor wafers 43. A dust protection plate 42 is mounted on the support frame 41. The dust protection plate 42 is positioned above the semiconductor wafers 43 so as to cover all of them. The operation of the semiconductor wafer support carrier according to the first embodiment is as follows.

When the semiconductor wafer support carrier 40 is drawn up from process liquid during a liquid phase process, dust in the process liquid is pushed aside out of the semiconductor wafers 43 by the dust protection plate 42. Therefore, the dust in the process liquid does not adhere to the surfaces of the semiconductor wafers 43 during the liquid phase process, so that later minute pattern forming process and the like semiconductor wafer manufacturing processes are not affected by the dust.

Next, two examples of the semiconductor wafer support carrier are indicated in Figs. 10 and 11.

Fig. 10 shows the result of the first example. In this case, a semiconductor wafer washing process which removes impurities from the surfaces of the semiconductor wafers, is carried out as the liquid phase process.

In Fig. 10, the horizontal position of the semiconductor wafer is taken along the horizontal axis, and the number of dust particles is taken along the vertical axis. In this case, the horizontal position of the semiconductor wafer means for example the position which is away at a distance L from the left end of the carrier 40. Moreover, the amount of dust which adheres to the surfaces of each semiconductor wafer and has diameters of over 0.3 µm, was measured. Semiconductor wafers having diameters of 5 inches (1 inch = 2.54 cm) were used. As is clear in Fig. 10, the amount of dust is reduced drastically in the case of a semiconductor support carrier having a dust protection plate as described herein, as compared with in the case of the conventional carrier. (For example, about several tens to three hundred particles of dust was reduced to about thirty).

Fig. 11 shows the results of the second example. In this case, the LPD process which forms SiO₂ films on the surfaces of the semiconductor wafers by precipitating reaction of a supersaturated solution, is carried out as the liquid phase process.

In Fig. 11, the horizontal position of the semiconductor wafer is taken along the horizontal axis, and the number of dust particles is taken along the vertical axis, as is similar to in Fig. 10. In the Fig. 11 the number of dust particles which have diameters of over 0.3 pm and which adhere to the surfaces of the semiconductor wafers, are shown. Semiconductor wafers having diameters of 5 inches are used.

As is clear in Fig. 11, the amount of dust is reduced in the case of the semiconductor wafer carrier having the dust protection plate and used as disclosed herein, as compared with in the case of the conventional carrier. (For example, trom one hundred to one thousand particles of dust to about several tens.)

Next, a second semiconductor wafer support carrier which may be used in accordance with the present invention is shown in Figs. 3 and 4.

In Figs. 3 and 4, a semiconductor wafer support carrier 50 is provided with a support frame 41 which contains and surrounds a plurality of semiconductor wafers 43. A dust protection plate 52 is mounted on the support frame 41, and is positioned above the semiconductor wafers 43 so as to cover all of them. The dust protection plate 52 consists of two parts each sliding on the top of the support frame 41.

In this case, it is easy to take the semiconductor wafers 43 in and out of the semiconductor wafer support carrier 50, by separating the two parts of the dust protection plate 52 before and after the liquid phase process (see Fig. 4).

Next, a third semiconductor wafer support carrier which may be used in accordance with the present invention is shown in Fig. 5.

In Fig. 5, a semiconductor wafer support carrier 60 is provided with a support frame 41 which contains and surrounds a plurality of semiconductor wafers 43. A dust protection plate 62 is mounted on the support frame 41. The dust protection plate 62 covers the upper portions and the side portions of the semiconductor wafers 43.

In this case, the adhering of dust to the surfaces of the semiconductor wafers 43 is definitely prevented.

Next, a fourth semiconductor wafer support carrier which may be used in accordance with the present invention is shown in Fig. 6.

In Fig. 6, a semiconductor warer support carrier 70 is provided with a support frame 41 which contains and surrounds a plurality of semiconductor wafers 43. A dust protection plate 72 which covers ther upper portions of the semiconductor wafers 43 is detachably mounted on the support frame 41. A handle 73 is secured to the dust protection plate 72. It is easy to detach the dust protection plate 72 from the support frame 41 by grasping the handle 73.

Next, a fifth semiconductor wafer support carrier which may be used in accordance with the present invention is shown in Fig. 7.

In Fig. 7, a semiconductor wafer support carrier 80 is provided with a support frame 41 which contains and surrounds a plurality of semiconductor wafers 43. Several dust protection plate 82 are mounted on the support frame 41 through support member 81. Each dust protection plate 82 covers the upper portions of one or more than two semiconductor wafers 43.

In this example, the adhering of dust to the surfaces of the specific semiconductor wafers 43 is definitely prevented.

Next, a sixth semiconductor wafer support carrier which may be used in accordance with the present invention is shown in Fig. 8.

In Fig. 8, a semiconductor wafer support carrier 90 is provided with a support frame 91 which supports a plurality of semiconductor wafers 43. A pair of dust protection plates 92 which cover the side portions of the semiconductor wafers 43, are mounted on the support frame 91 through a connection member (not shown). The upper ends 93 of the dust protection plates 92 are bent inward, and partially cover the upper portions of the semiconductor wafers 43.

When the semiconductor wafer support carrier 90 is drawn up from the process liquid during the liquid phase process, the process liquid is pushed aside by the bending upper ends 93, and the dust in the process liquid is also pushed aside. It is easy to take the semiconductor wafers 43 in and out of the semiconductor wafer support carrier 90 through the space between the upper ends 93 of the dust protection plate 92.

Next, a seventh semiconductor wafer support carrier which may be used in accordance with the present invention is shown in Fig. 9.

In Fig. 9, a semiconductor wafer support carrier 95 is provided with a support frame 91 which supports a plurality of semiconductor wafers 43. A dust protection plate 96 is mounted on the support frame 91 through a connection member (not shown). The dust protection plate 96 covers the side and upper portions of the semiconductor wafers 43.

## Claims

1. Use of a semiconductor wafer support carrier (40, 50, 60, 70, 80) in the processing, in a liquid, of a semiconductor wafer (43), for preventing dust from adhering to the surfaces of said wafer supported in said carrier when the carrier and wafer are drawn up from the process liquid, the support carrier comprising:
- a support frame (41,91)) supporting the semiconductor wafer (43), and
- a dust protection plate (42, 52, 62, 72, 82, 96) mounted on the support frame (41) and positioned above the semiconductor wafer (43) so as to cover the same, wherein the semiconductor wafer support carrier is drawn up from the process liquid during said processing and dust in the process liquid is pushed away from the wafer by said dust protection plate.

2. Use of a semiconductor wafer support carrier as claimed in claim 1, wherein the dust protection plate (52) consists of two parts.

3. Use of a semiconductor wafer support carrier as claimed in claim 2, wherein the two parts are able to slide on the support frame (41).

4. Use of a semiconductor wafer support carrier as claimed in claim 1, wherein the dust protection plate (72) is detachably mounted on the support frame (41), and a handle (73) is secured to the dust protection plate (72) .

5. Use of a semiconductor wafer support carrier (90) in the processing, in a liquid, of a semiconductor wafer (43), for preventing dust from adhering to the surfaces of said wafer supported in said carrier when the carrier and wafer are drawn up from the process liquid, the support carrier comprising:
- a support frame (91) supporting the semiconductor wafer (43), and
- two vertical dust protection plates (92) mounted on the support frame (90) with the wafer (43) positioned vertically between them, wherein the upper end (93) of each of said dust protection plates is bent inwardly, the upper edge of the wafer being situated below said inwardly bent portions so that as the semiconductor wafer support carrier (90) is drawn up from the process liquid during said processing, dust in the process liquid is pushed away from the wafer by the inwardly bent ends (93) of the dust protection plates (92).

## Patentansprüche

1. Verwendung eines Halbleiterwafer-Halteträgers (40, 50, 60, 70, 80) bei der Verarbeitung eines Halbleiterwafers (43) in einer Flüssigkeit, um ein Anhaften von Staub an die Oberflächen des Wafers, der in dem Träger gehalten wird, zu verhindern, wenn der Träger und Wafer aus der Verarbeitungsflüssigkeit entnommen werden, wobei der Halteträger umfaßt:
- einen Halterahmen (41 91), der den Halbleiterwafer (43) hält, und
- eine Staubschutzplatte (42, 52, 62, 72, 82, 96), die an dem Halterahmen (41) angebracht ist und über dem Halbleiterwafer (43) positioniert ist, um diesen zu überdecken, wobei der Halbleiterwafer-Halteträger während der Verarbeitung aus der Verarbeitungsflüssigkeit entnommen wird, und Staub in der Verarbeitungsflüssigkeit mittels der Staubschutzplatte von dem Wafer weggedrängt wird.

2. Verwendung eines Halbleiterwafer-Halteträgers nach Anspruch 1, dadurch gekennzeichnet, daß die Staubschutzplatte (52) aus zwei Teilen besteht.

3. Verwendung eines Halbleiterwafer-Halteträgers nach Anspruch 2, dadurch gekennzeichnet, daß die zwei Teile in der Lage sind, auf dem Halterahmen (41) zu gleiten.

4. Verwendung eines Halbleiterwafer-Halteträgers nach Anspruch 1, dadurch gekennzeichnet, daß die Staubschutzplatte (72) abnehmbar an dem Halterahmen (41) angebracht ist und ein Griff (73) an der Staubschutzplatte (72) angebracht ist.

5. Verwendung eines Halbleiterwafer-Halteträgers (90) bei der Verarbeitung eines Halbleiterwafers (43) in einer Flüssigkeit, um ein Anhaften von Staub an die Oberflächen des Wafers, der in dem Träger gehalten wird, zu verhindern, wenn der Träger und Wafer aus der Verarbeitungsflüssigkeit entnommen werden, wobei der Halteträger umfaßt:
- einen Halterahmen (91), der den Halbleiterwafer (43) hält, und
- zwei vertikale Staubschutzplatten (92), die an dem Halterahmen (90) mit dem Wafer (43) vertikal dazwischen positioniert angebracht sind, wobei das obere Ende (93) von jeder der Staubschutzplatten einwärtsgekrümmt ist, wobei die obere Kante des Wafers unterhalb der einwärtsgekrümmten Abschnitte so angeordnet ist, daß, wenn der Halbleiterwafer-Halteträger (90) während der Verarbeitung aus der Verarbeitungsflüssigkeit entnommen wird, Staub in der Verarbeitungsflüssigkeit mittels der einwärtsgekrümmten Enden (93) der Staubschutzplatten (92) von dem Wafer weggeschoben wird.

## Revendications

1. Utilisation d'un support de pastille semi-conductrice (40, 50, 60, 70, 80) durant le traitement, dans un liquide d'une pastille semi-conductrice (43), pour empêcher que de la poussière adhère aux surfaces de ladite pastille supportée par ledit support lorsque le support et la pastille sont retirés du liquide de traitement, le support comprenant :
- un cadre de support (41, 91) supportant la pastille semi-conductrice (43), et
- une plaque de protection contre la poussière (42, 52, 62, 72, 82, 96) montée sur le cadre de support (41) et positionnée au-dessus de la pastille semi-conductrice (43) de manière à recouvrir celle-ci, dans lequel le support de pastille semi-conductrice est retiré du liquide de traitement durant ledit traitement et la poussière qui se trouve dans le liquide de traitement est poussée en dehors de la pastille par ladite plaque de protection contre la poussière.

2. Utilisation d'un support de pastille semi-conductrice selon la revendication 1, dans laquelle la plaque de protection contre la poussière (52) est composée de deux parties.

3. Utilisation d'un support de pastille de semi-conducteur selon la revendication 2, dans laquelle les deux parties peuvent coulisser sur le cadre de support (41).

4. Utilisation d'un support de pastille semi-conductrice selon la revendication 1, dans laquelle la plaque de protection contre la poussière (72) est montée, de façon à pouvoir être détachée, sur le cadre de support (41), et une poignée (73) est fixée sur la plaque de protection contre la poussière (72).

5. Utilisation d'un support de pastille semi-conductrice (90) durant le traitement, dans un liquide, d'une pastille semi-conductrice (43), pour empêcher que de la poussière adhère sur les surfaces de ladite pastille supportée par ledit support, lorsque le support et la pastille sont retirés du liquide de traitement, le support comprenant :
- un cadre de support (91) supportant la pastille semi-conductrice (43), et
- deux plaques verticales de protection contre la poussière (92) qui sont montées sur le cadre de support (90), la pastille (43) étant positionnée entre celles-ci dans la direction verticale, dans lesquelles l'extrémité supérieure (93) de chacune desdites plaques de protection contre la poussière est recourbée vers l'intérieur, le bord supérieur de la pastille étant situé en dessous desdites parties recourbées vers l'intérieur, de telle façon que lorsque le support de pastille semi-conductrice (90) est retiré du liquide de traitement durant ledit traitement, la poussière qui se trouve dans le liquide de traitement est poussée en dehors de la pastille par les extrémités recourbées vers l'intérieur (93) des plaques de protection contre la poussière (92).
